(19) Europäisches Patentamt
European Patent Office
Office européen des brevets

(11) **EP 4 109 177 A1**

(12) **EUROPEAN PATENT APPLICATION**
published in accordance with Art. 153(4) EPC

(43) Date of publication:
**28.12.2022 Bulletin 2022/52**

(21) Application number: **21756231.3**

(22) Date of filing: **08.02.2021**

(51) International Patent Classification (IPC):
*G03F 1/42* *(2012.01)*

(52) Cooperative Patent Classification (CPC):
**G03F 1/42; G03F 7/70683; G03F 9/00; G03F 9/7076**

(86) International application number:
**PCT/CN2021/075946**

(87) International publication number:
**WO 2021/164608 (26.08.2021 Gazette 2021/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.02.2020 CN 202010109639**

(71) Applicant: **Changxin Memory Technologies, Inc.**
**Hefei, Anhui 230601 (CN)**

(72) Inventor: **FAN, Congcong**
**Hefei, Anhui 230601 (CN)**

(74) Representative: **Lavoix**
**Bayerstraße 83**
**80335 München (DE)**

(54) **MASK APPLIED TO SEMICONDUCTOR PHOTOLITHOGRAPHY TECHNIQUE, AND PHOTOLITHOGRAPHY TECHNIQUE METHOD**

(57)    The present application provides a mask applied to semiconductor photolithography and a photolithographic method, and the mask includes at least one pattern group, each pattern group including at least one light-transmitting region and at least one shielding region, the light-transmitting regions and the shielding regions being arranged at intervals, and after exposure, each pattern group forming an independent mark on a wafer. The present application has the following advantages. The independent mark formed on the wafer according to the mask has the same shape as a contour of a pattern of the mask, and does not have a pattern defect, which improves accuracy of an independent mark pattern formed on the wafer, and then alignment precision of the semiconductor photolithography as well as overlaying accuracy in a following semiconductor process, thus increasing a quality and a yield of products.

**FIG. 2**

**Description**

REFERENCE TO RELATED APPLICATION

This application claims priority to Chinese Patent Application No. 202010109639.9, entitled "MASK APPLIED TO SEMICONDUCTOR PHOTOLITHOGRAPHY AND PHOTOLITHOGRAPHIC METHOD" and filed on February 22, 2020, the entire contents of which are appended herein by reference.

FILED OF THE INVENTION

The present application relates to the field of semiconductor fabrication, in particular to a mask applied to semiconductor photolithography and a photolithographic method.

BACKGROUND OF THE INVENTION

With a development of a semiconductor manufacturing technology, semiconductor chips have smaller and smaller areas, and therefore, precision of the semiconductor technology becomes more important. In a manufacturing process of the semiconductor technology, an important processing step is photolithography, in which a pattern on a mask is mainly transferred onto a wafer, and then, other subsequent technological processes may be performed to complete fabrication of a whole semiconductor device. Therefore, a quality of the photolithography directly affects a performance of the final semiconductor device.

Currently, a pattern of a mark formed after the pattern on the mask is transferred onto the wafer may have a changed size or shape, or even not be shown, which affects the performance of the semiconductor device.

For example, alignment is one of the most important mechanisms for a photolithographic system, and alignment precision is positioning precision of an interlayer pattern in multi-layer exposure, and serves as an important index of the photolithographic system in a semiconductor production process.

Alignment marks are required for the alignment. The alignment marks currently used for a SMASH system are mainly DPCM, NSSM11, NSSM53, XPAAA5, BF2u3F, or the like. A machine of the photolithographic system may pre-compensate for a pattern overlaying deviation of a part of the wafer caused by a previous technological process via measurement and analysis operations of a coarse/fine alignment pattern.

A manufacturing process of the alignment mark includes the steps of designing a mask corresponding to the alignment mark; and transferring a pattern on the mask onto a wafer by a photolithographic system, and then forming the alignment mark on the wafer. Generally, the pattern may be transferred onto the wafer normally. However, in some special cases, for example, in the case of a high transmittance mask, under an influence of a side-lobe effect, after transferred onto the wafer, the pattern may have a changed size or shape, or even not be displayed. Abnormal transfer of the pattern may prevent formation of a standard alignment mark on the wafer, which affects the precision of the photolithographic system, for example, the alignment precision, and further reduces overlaying accuracy in the subsequent process, thus affecting a quality and a yield of products.

Therefore, how to form the standard mark on the wafer is a technical problem urgent to be solved currently.

SUMMARY OF THE INVENTION

In order to solve the technical problem, the present application provides a mask applied to semiconductor photolithography and a photolithographic method, which may form a standard independent mark on a wafer, and improve a performance of a photolithographic system as well as a quality and a yield of products.

In order to solve the above-mentioned problem, the present application provides a mask applied to semiconductor photolithography, including: at least one pattern group, each pattern group including at least one light-transmitting region and at least one shielding region, the light-transmitting regions and the shielding regions being arranged at intervals, and after exposure, each pattern group forming an independent mark on a wafer.

Further, both the light-transmitting region and the shielding region in the pattern group are rectangular.

Further, the light-transmitting region has a same length as the shielding region.

Further, the independent mark is rectangular.

Further, the light-transmitting region and the shielding region have widths satisfying the following formula:

$$PITCH \leq \lambda/((1+\sigma)*NA)$$

wherein PITCH is a sum of the widths of the light-transmitting region and the shielding region, $\lambda$ is a wavelength used in the photolithography, $\sigma$ is a ratio of an inner diameter and an outer diameter of a diffractive optical element used in the photolithography, and NA is a numerical aperture used in the photolithography.

Further, the shielding region has a light transmittance 0.06-0.3 times that of the light-transmitting region.

Further, the light-transmitting regions are arranged in parallel.

Further, the light-transmitting regions and the shielding regions are arranged at intervals in a horizontal direction, a vertical direction or a direction forming an acute angle with the horizontal direction.

Further, the mask includes an alignment pattern region and a chip pattern region, the pattern group being provided at the alignment pattern region, and the independent mark being used as an alignment mark of the wafer.

Further, the alignment mark includes alignment marks of the same layer and alignment marks between layers.

The present application further provides a photolithographic method in which the mask as mentioned above is used to form an alignment mark on a wafer.

The present application has the following advantages. On the mask, the pattern group is formed by arranging the light-transmitting regions and the shielding regions at intervals, and during exposure, the independent mark formed on the wafer according to the pattern group has a same shape as a contour of the pattern group, and does not have a pattern defect, which improves accuracy of the independent mark pattern formed on the wafer, alignment precision of the photolithographic system, and overlaying accuracy in a following semiconductor process, thus increasing the quality and the yield of the products.

BRIEF DESCRIPTION OF THE DRAWINGS

To describe the technical solutions in the embodiments of the present application more clearly, the following briefly describes the accompanying drawings required in the embodiments of the present application. Apparently, the accompanying drawings in the following description show merely some embodiments of the present application, and a person of ordinary skill in the art may still derive other drawings from these accompanying drawings without creative efforts.

Figure 1 is a schematic diagram of a mask pattern used to form an alignment mark and the alignment mark formed by transferring the mask pattern onto a wafer, with (a) being the mask pattern and (b) being the alignment mark finally formed on the wafer;

Figure 2 is a schematic diagram of a first embodiment of a pattern group of a mask according to the present application and a schematic diagram of an independent mark formed using the mask, with (a) being a schematic diagram of a pattern of the mask and (b) being a schematic diagram of a pattern of the independent mark formed on a wafer;

Figure 3 is another schematic structural diagram of the mask;

Figure 4 is a schematic diagram of a second embodiment of a pattern group of a mask according to the present application and a schematic diagram of an independent mark formed using the mask, with (a) being a schematic diagram of a pattern of the mask and (b) being a schematic diagram of a pattern of the independent mark formed on a wafer;

Figure 5 is a schematic diagram of a third embodiment of a pattern group of a mask according to the present application and a schematic diagram of an independent mark formed using the mask, with (a) being a schematic diagram of a pattern of the mask and (b) being a schematic diagram of a pattern of the independent mark formed on a wafer; and

Figure 6 is a schematic diagram of formation of an alignment mark on a wafer using a mask.

DETAILED DESCRIPTION OF THE EMBODIMENTS

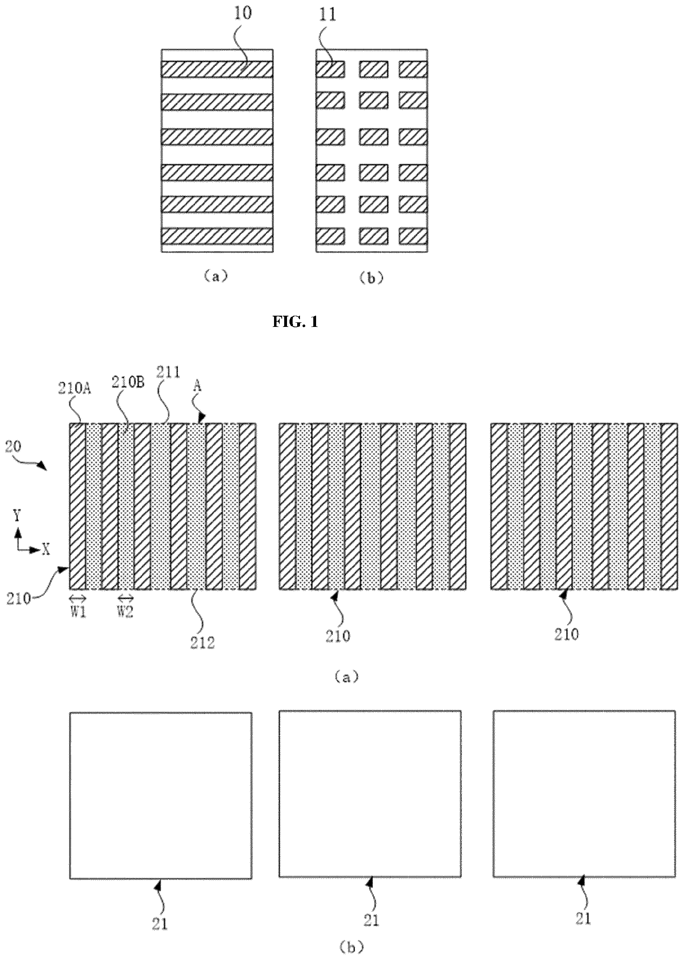

To make the objectives, technological means and effects thereof of the present application clearer, the following further describes the present application with reference to the accompanying drawings. It should be understood that the embodiments described herein are merely some but not all of the embodiments of the present application, and are not intended to limit the present application. All other embodiments obtained by those skilled in the art based on the embodiments of the present application without creative efforts shall fall within the protection scope of the present application. The inventor has discovered that various defects may occur when a pattern on a mask is transferred onto a wafer in photolithography. In particular, the defects are more obvious for an alignment mark formed on the wafer. For example, Figure 1 is a schematic diagram of a mask pattern used to form an alignment mark and the alignment mark formed by transferring the mask pattern onto a wafer, with GDS Level being the mask pattern and Wafer Level being the alignment mark finally formed on the wafer. Referring to Figure 1, the pattern 10 of a mask is a large-size line, and a pattern 11 in the alignment mark formed on the wafer is a short line; that is, the pattern of the alignment mark has a changed size.

After research, the inventor provides a novel mask. In the photolithography, the alignment mark formed on the wafer with this mask may overcome the above-mentioned defects and form a standard independent mark.

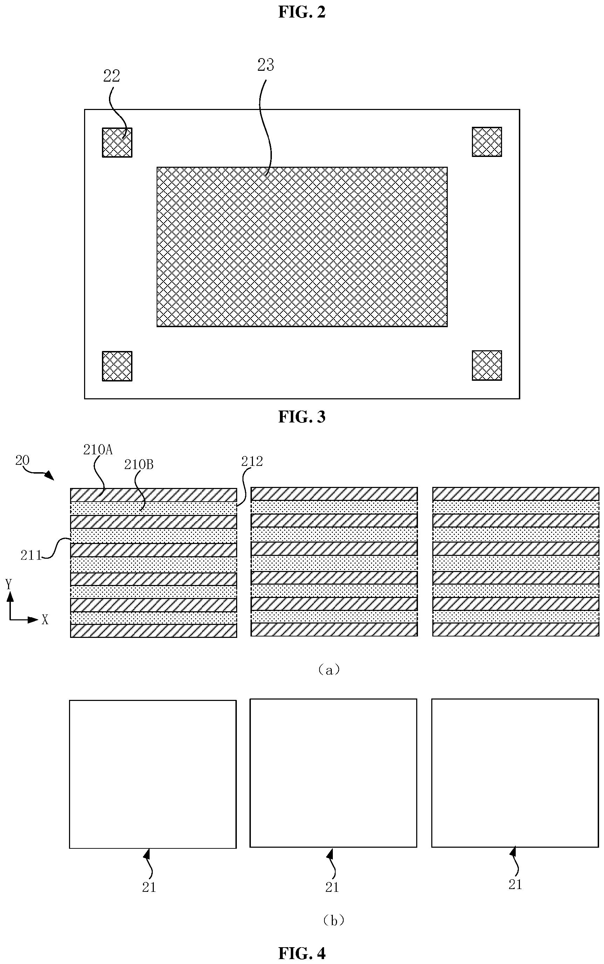

Figure 2 is a schematic diagram of a first embodiment of a pattern group of a mask according to the present application and a schematic diagram of an independent mark formed using the mask, with (a) being a schematic diagram of a pattern of the mask and (b) being a schematic diagram of a pattern of the independent mark formed on a wafer.

Referring to Figure 2, the mask 20 includes at least one pattern group 210. After the pattern of the mask 20 is transferred onto the wafer, one independent mark 21 is formed in a corresponding region of the pattern group 210 on the wafer. Specifically, the pattern group 210 has a same contour (as shown by the dotted line A in Figure 2) as the independent mark 21. That is, the contour of the pattern group 210 has a same shape as the contour of the independent mark 21; for example, a pattern group 210 having a rectangular contour is required to be formed if a rectangular independent mark 21 is to be formed, and a pattern group 210 having a cross-shaped contour is required to be formed if a cross-shaped independent mark 21 is to be formed. Further, depending on the shape of the independent mark 21, the pattern group 210 may be a regular pattern, such as a rectangle, or the like, or an irregular pattern, such as a pattern having an irregular contour. In the present embodiment, the pattern group 210 has a rectangular contour, so as to form a rectangular independent mark.

In the present embodiment, only three pattern groups 210 are shown schematically. In other embodiments, other numbers of pattern groups 210 may be provided according to requirements of the independent marks 21 formed on the wafer; for example, in another embodiment of the present application, if one independent mark is required to be formed on the wafer, one pattern group 210 is necessary to be provided on the mask.

The pattern group 210 includes at least one light-transmitting region 210A and at least one shielding region 210B. In the present embodiment, the pattern group 210 includes a plurality of light-transmitting regions 210A and a plurality of shielding regions 210B. The light-transmitting region 210A has a light transmittance greater than the shielding region 210B. In subsequent photolithography, light may be irradiated onto the wafer through the light-transmitting region 210A.

The light-transmitting regions 210A and the shielding regions 210B are arranged at intervals. Specifically, the light-transmitting regions 210A and the shielding regions 210B are arranged at intervals in a horizontal direction, a vertical direction or a direction forming an acute angle with the horizontal direction. For example, in the present embodiment, the light-transmitting regions 210A and the shielding regions 210B are arranged at intervals in the horizontal direction (X direction). The light-transmitting region 210A extends in a direction. The direction is perpendicular to the arrangement direction of the light-transmitting regions 210A and the shielding regions 210B. Specifically, in the present embodiment, the light-transmitting region 210A and the shielding region 210B extend in the vertical direction. That is, in the present embodiment, the plurality of light-transmitting regions 210A are parallel to each other and extend in a Y direction, and the light-transmitting regions 210A and the shielding regions 210B are arranged at intervals in the X direction to form the pattern group 210.

The light-transmitting region 210A may extend from a first edge to a second edge of the pattern group 210. Specifically, referring to Figure 2, the light-transmitting region 210A extends from the first edge 211 to the second edge 212 of the pattern group 210, and the first and second edges 211, 212 are not adjacent to each other but disposed opposite to each other.

Further, in the present embodiment, the light-transmitting region 210A and the shielding region 210B are both rectangular, and have equal lengths, such that the pattern group 210 formed by the light-transmitting region 210A and the shielding region 210B is also rectangular. In other embodiments of the present application (for example, the second embodiment of the present application), the plural light-transmitting regions 210A may have unequal lengths, the shielding regions 210B may have unequal lengths, and the light-transmitting region 210A and the shielding region 210B may have unequal lengths.

When the mask according to the present application is used for exposure, on the wafer, not only the region corresponding to the light-transmitting region 210A is irradiated by light and influenced by characteristics of the light passing through the light-transmitting region 210A, but also the region corresponding to the shielding region 210B is irradiated by light, such that the independent mark 21 having the same contour shape as the pattern group 210 of the mask is formed on the wafer. The independent mark 21 has an independent overall pattern.

Further, the light-transmitting region 210A has a width W1, the shielding region 210B has a width W2, and in order to enable the pattern group 210 to form the independent mark, the widths W1, W2 of the light-transmitting region 210A and the shielding region 210B are required to satisfy the following formula:

$$PITCH \leq \lambda/((1+\sigma)*NA)$$

wherein PITCH is a sum of the widths W1, W2 of the light-transmitting region 210A and the shielding region 210B, $\lambda$ is a wavelength used in the photolithography, $\sigma$ is a ratio of an inner diameter and an outer diameter of a diffractive optical element used in the photolithography, and NA is a numerical aperture used in the photolithography. It may be seen that the independent mark 21 having the same shape as the pattern group 210 may be formed on the wafer only when the sum of the widths W1, W2 of the light-transmitting region 210A and the shielding region 210B is less than $\lambda/((1+\sigma)*NA)$.

In order to further ensure that the pattern group 210 may form the independent mark, the shielding region 210B has a light transmittance 0.06-0.3 times that of the light-transmitting region 210A, if the shielding region 210B has an over low light transmittance, the independent mark formed by the pattern group 210 may be a pattern formed by a plurality of bars, and if the shielding region 210B has an over high light transmittance, the independent mark formed by the pattern group 210 may have a pattern defect, and is unable to form a standard independent mark pattern.

In the present application, the pattern group 210 is divided into the plurality of light-transmitting regions 210A and shielding regions 210B which are arranged at intervals, and compared with an integral pattern group, the independent mark 21 formed by the pattern group 210 according to the present application has the same shape as the contour of the pattern group 210 without the above-mentioned pattern defect, which improves accuracy of the independent mark pattern, then alignment precision of a photolithographic system, and overlaying accuracy in a subsequent process, thus increasing a quality and a yield of products.

Further, the light-transmitting region 210A and the shielding region 210B may have equal or unequal widths which may be selected appropriately according to different parameters of different photolithographic machines, such that the final independent mark 21 has the same shape as the contour of the pattern group 210, and better meets requirements.

Further, the independent mark may be an alignment mark. Specifically, Figure 3 is a schematic structural diagram of the mask, and the mask 20 includes an alignment pattern region 22 and a chip pattern region 23. The pattern group 210 is provided at the alignment pattern region 22 to form the alignment mark on the wafer. The chip pattern region 23 may form a chip structure on the wafer.

The alignment mark formed on the wafer may be used for alignment of the same layer or different layers (i.e., overlaying alignment). Specifically, when operations are required to be performed on different regions of the same layer of the wafer, an alignment step is required to be performed before the operation on each region, and an alignment mark adopted in the alignment step is the mark formed using the mask according to the present application. When operations are required to be performed on different layers of the wafer, the alignment step shall be performed before the operation on each layer, and the alignment mark adopted in the alignment step is the mark formed using the mask according to the present application.

There is further provided a mask according to a second embodiment of the present application. Figure 4 is a schematic diagram of a second embodiment of a pattern group of a mask according to the present application and a schematic diagram of an independent mark formed using the mask, with (a) being a schematic diagram of a pattern of the mask and (b) being a schematic diagram of a pattern of the independent mark formed on a wafer. Referring to Figure 4, the second embodiment is different from the first embodiment in that the light-transmitting region 210A and the shielding region 210B have different arrangement and extending directions.

Specifically, in the second embodiment, the light-transmitting regions 210A and the shielding regions 210B are arranged in parallel in the vertical direction (Y direction) and extend in the horizontal direction (X direction). The light-transmitting region 210A and the shielding region 210B extend from the first edge 211 to the second edge 212 of the pattern group 210, and the first and second edges 211, 212 are not adjacent to each other and disposed opposite to each other. That is, in the present embodiment, the plurality of horizontal light-transmitting regions 210A and shielding regions 210B are arranged at intervals in the vertical direction to form the pattern group 210.

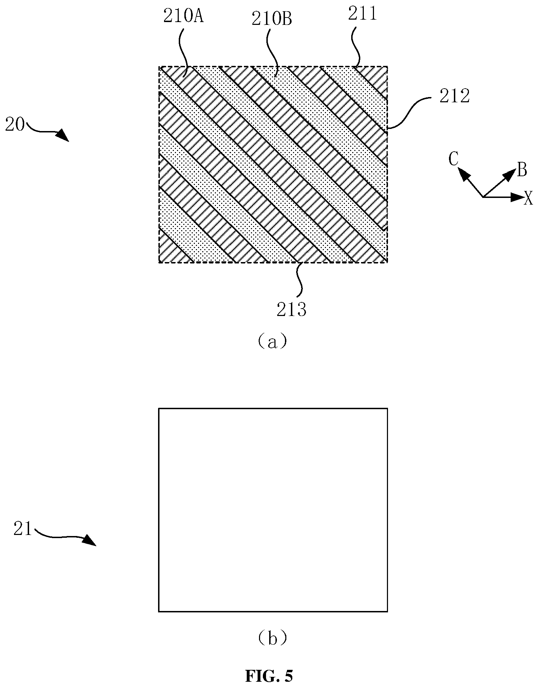

There is further provided a mask according to a third embodiment of the present application. Figure 5 is a schematic diagram of a third embodiment of a pattern group of a mask according to the present application and a schematic diagram of an independent mark formed using the mask, with (a) being a schematic diagram of a pattern of the mask and (b) being a schematic diagram of a pattern of the independent mark formed on a wafer. Referring to Figure 5, the third embodiment is different from the first embodiment in that the light-transmitting region 210A and the shielding region 210B have different arrangement and extending directions, and only one pattern group 210 is schematically shown in Figure 5.

Specifically, in the third embodiment, the light-transmitting regions 210A and the shielding regions 210B are arranged in parallel in a direction (B direction) forming an acute angle with the horizontal direction and extend in a direction (C direction) forming an obtuse angle with the horizontal direction. A part of the light-transmitting regions 210A and a part of the shielding regions 210B extend from the first edge 211 to the second edge 212 of the pattern group 210, and the first edge 211 is adjacent to the second edge 212; a part of the light-transmitting regions 210A and a part of the shielding regions 210B extend from the first edge 211 to a third edge 213 of the pattern group 210, and the first and third edges 211, 213 are not adjacent to each other and disposed opposite to each other. That is, in the present embodiment, the plurality of oblique light-transmitting regions 210A and shielding regions 210B are arranged at intervals in the direction forming an acute angle with the horizontal direction to form the pattern group 210.

Further, in the third embodiment, the light-transmitting region 210A and the shielding region 210B have unequal lengths which depend on a position of the contour of the pattern group 210 formed by the light-transmitting region 210A and the shielding region 210B; for example, the light-transmitting region 210A located in a corner area of the pattern group 210 has a length less than the light-transmitting region 210A located in a middle area of the pattern group 210.

It may be understood that the arrangement and extending directions of the light-transmitting region 210A and the shielding region 210B are not limited in the mask according to the present application, as long as the light-transmitting region 210A and the shielding region 210B have coincident extending directions to form the pattern group.

The present application further provides a photolithographic method, and during exposure, the above-mentioned mask is adopted to form the independent mark on the wafer.

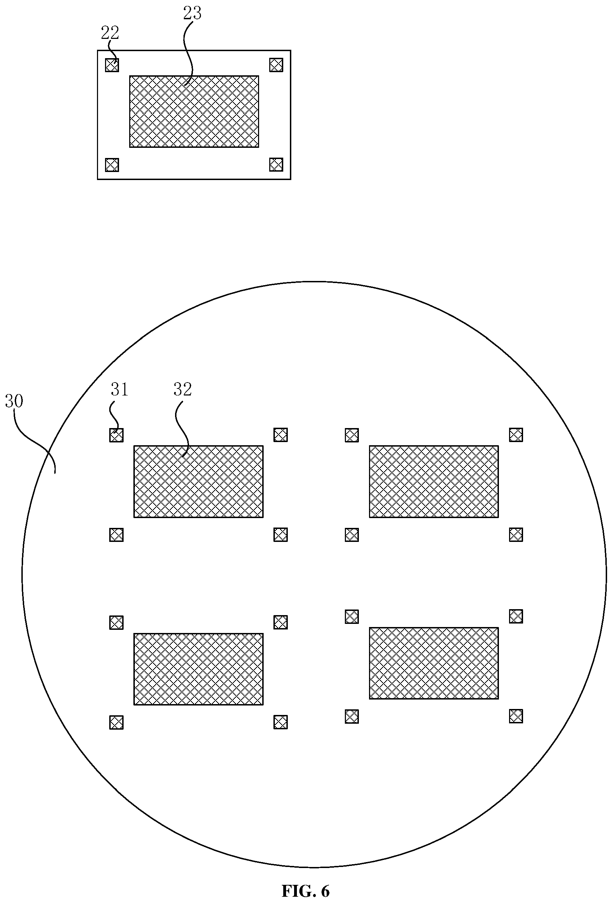

The following description will be made by taking an example of forming the alignment mark on the wafer. Referring to Figure 6, which is a schematic diagram of formation of an alignment mark on a wafer using a mask, the mask 20 includes an alignment pattern region 22 and a chip pattern region 23, and the pattern group 210 is provided at the alignment pattern region 22. During exposure, light is transmitted through the pattern group 210 into a corresponding region of the wafer, the pattern group 210 forms the alignment mark 31 on the wafer 30, and meanwhile, the light is transmitted through the chip pattern region 23 into a corresponding region of the wafer, and the chip pattern region 23 forms a chip structure 32 on the wafer 30. Further, the mask 20 may be moved to form a plurality of chip structures 32 and alignment marks 31 on the wafer.

In the photolithographic method according to the present application, the above-mentioned mask structure is used as a mask, and may form the standard independent mark meeting requirements on the wafer, thereby improving the accuracy of the subsequent process to increase the quality and the yield of the products.

The above is only preferred implementations of the application. It shall be pointed out that those skilled in the art may also make some improvements and modifications without departing from the principle of the application. These improvements and modifications shall fall within the protective scope of the application.

**Claims**

1. A mask applied to semiconductor photolithography, comprising: at least one pattern group, each pattern group comprising at least one light-transmitting region and at least one shielding region, the light-transmitting regions and the shielding regions being arranged at intervals, and after exposure, each pattern group forming an independent mark on a wafer.

2. The mask according to claim 1, wherein both the light-transmitting region and the shielding region in the pattern group are rectangular.

3. The mask according to claim 2, wherein the light-transmitting region has a same length as the shielding region.

4. The mask according to claim 2, wherein the independent mark is rectangular.

5. The mask according to claim 2, wherein the light-transmitting region and the shielding region have widths satisfying the following formula:

$$PITCH \leq \lambda/((1+\sigma)*NA)$$

wherein PITCH is a sum of the widths of the light-transmitting region and the shielding region, $\lambda$ is a wavelength used in the photolithography, $\sigma$ is a ratio of an inner diameter and an outer diameter of a diffractive optical element used in the photolithography, and NA is a numerical aperture used in the photolithography.

6. The mask according to claim 1, wherein the shielding region has a light transmittance 0.06-0.3 times that of the light-transmitting region.

7. The mask according to claim 1, wherein the light-transmitting regions are arranged in parallel.

8. The mask according to claim 1, wherein the light-transmitting regions and the shielding regions are arranged at intervals in a horizontal direction, a vertical direction or a direction forming an acute angle with the horizontal direction.

9. The mask according to claim 1, wherein the mask comprises an alignment pattern region and a chip pattern region, the pattern group being provided at the alignment pattern region, and the independent mark being used as an alignment mark of the wafer.

10. The mask according to claim 9, wherein the alignment mark comprises alignment marks of the same layer and alignment marks between layers.

11. A photolithographic method in which the mask according to claim 1 is used to form an alignment mark on a wafer.

**FIG. 1**

**(a)**

**(b)**

**(a)**

**(b)**

**FIG. 2**

**FIG. 3**

（a）

（b）

**FIG. 4**

210A   210B   211

212

20

C   B

X

213

（a）

21

（b）

**FIG. 5**

**FIG. 6**

## INTERNATIONAL SEARCH REPORT

| International application No. |
|---|
| **PCT/CN2021/075946** |

### A. CLASSIFICATION OF SUBJECT MATTER

G03F 1/42(2012.01)i

According to International Patent Classification (IPC) or to both national classification and IPC

### B. FIELDS SEARCHED

Minimum documentation searched (classification system followed by classification symbols)

G03F1, H01L21

Documentation searched other than minimum documentation to the extent that such documents are included in the fields searched

Electronic data base consulted during the international search (name of data base and, where practicable, search terms used)

VEN; CNABS; CNTXT: 掩模, 掩膜, 标记, 校准, 对位, 对准, 校正, 透, 遮, 间隔, 交替, 重复, 辅助, 图形, 图案, photomask? , photo mask? , mark? , alignment, transpar+, transmit+, shad+, interv+, alter+, distanc+, spac+, array, auxiliary, pattern, 长江存储, 长鑫存储

### C. DOCUMENTS CONSIDERED TO BE RELEVANT

| Category* | Citation of document, with indication, where appropriate, of the relevant passages | Relevant to claim No. |
|---|---|---|
| PX | CN 111443570 A (YANGTZE MEMORY TECHNOLOGIES CO., LTD.) 24 July 2020 (2020-07-24) description, paragraphs 46-67, and figures 4-8 | 1-11 |
| X | US 2008225254 A1 (KOMINE NOBUHIRO et al.) 18 September 2008 (2008-09-18) description, paragraphs 64-104, figures 1-4, 9-14 | 1-11 |
| X | US 2017357154 A1 (SAMSUNG ELECTRONICS CO., LTD.) 14 December 2017 (2017-12-14) description, paragraphs 31-92, and figures 1-3 | 1-11 |
| X | US 2016266484 A1 (TOSHIBA K. K.) 15 September 2016 (2016-09-15) description, paragraphs 39-48, and figures 4-6 | 1-11 |
| X | US 2018210332 A1 (NIKON CORP.) 26 July 2018 (2018-07-26) description, paragraphs 40-44, and figures 1-5 | 1-11 |
| X | CN 110764377 A (JIANGSU SHANGDA ELECTRONIC CO., LTD.) 07 February 2020 (2020-02-07) description, paragraphs 24-33, and figures 3-4 | 1-11 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **22 April 2021** | **17 May 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2021/075946**

| Patent document cited in search report | | | Publication date (day/month/year) | Patent family member(s) | | | Publication date (day/month/year) |
|---|---|---|---|---|---|---|---|
| CN | 111443570 | A | 24 July 2020 | None | | | |
| US | 2008225254 | A1 | 18 September 2008 | US | 7906258 | B2 | 15 March 2011 |
| | | | | JP | 2008225224 | A | 25 September 2008 |
| | | | | JP | 4864776 | B2 | 01 February 2012 |
| US | 2017357154 | A1 | 14 December 2017 | KR | 20170141312 | A | 26 December 2017 |
| | | | | US | 9846359 | B1 | 19 December 2017 |
| US | 2016266484 | A1 | 15 September 2016 | US | 9703912 | B2 | 11 July 2017 |
| US | 2018210332 | A1 | 26 July 2018 | US | 10871708 | B2 | 22 December 2020 |
| CN | 110764377 | A | 07 February 2020 | None | | | |

Form PCT/ISA/210 (patent family annex) (January 2015)

**REFERENCES CITED IN THE DESCRIPTION**

**Patent documents cited in the description**

- CN 202010109639